# EUROPEAN PATENT APPLICATION

(11) **EP 0 722 181 A1**
(43) Date of publication of application: **17.07.1996**
(21) Application number: 94924392.7
(22) Date of filing: 19.08.1994
(51) Int. Cl.: H01J 37/317, H01L 21/265

(54) **IONEN IMPLANTIERUNGSGERÄT**

(30) Priority: 20.08.1993 JP 206742/93
(71) Applicant: OHMI, Tadahiro, Sendai-shi Miyagi-ken 980 (JP)
(72) Inventor: OHMI, Tadahiro, Miyagi-ken 980 (JP); TOMITA, Kazuo, Dept. Elect. Faculty of Engineering, Sendai-shi, Miyagi-ken 980 (JP)
(74) Representative: Weitzel, Wolfgang, Dr.-Ing. Patentanwalt
(86) International application number: JP9401374
(87) International publication number: WO9506953

(57) **Abstract**

An object of the present invention is to provide an ion implanter in which contamination of metallic impurities is reduced.

The ion implanter for introducing specified impurities into said semiconductor substrate by irradiating an ion beam accelerated against the semiconductor substrate is characterized in that a portion of a member positioned at a place backward from said semiconductor substrate and irradiated by the ion beam when viewed from a direction in which the ion beam advanced is made of semiconductor constituting said semiconductor substrate or a material containing at least an oxide or a nitride thereof as a main ingredient, or the surface thereof is covered with said material.

Also the ion implanter is characterized in that a member positioned at a place backward from said semiconductor substrate, when viewed from a direction in which the ion beam advances, is not irradiated by said ion beam.

## Description

### FIELD OF THE INVENTION

The present invention relates to an ion implanter, and more particularly to an ion implanter which reduces a degree of contamination by metallic impurities and is suited to manufacture of high performance semiconductor device.

### BACKGROUND ART

At present, the semiconductor integrated circuit technology has been progressing at a surprisingly high speed, and in association with a minimization of a size of an element from 0.8 µm to 0.5 µm or below, formation of an extremely shallow junction, in which a leak current in the reverse direction is generated little, has been increasingly important.

In order to form a P type of an N-type of extremely shallow junction within a silicon substrate using an ion implanter, it is required either to carry out the manufacturing process under a low temperature so that impurities will not be diffused in the subsequent heat processing at all, or to execute the heat processing within a short period of time under a high temperature. However, even though the processing is executed within a short period of time, if it is carried out under a high temperature, introduced impurities will always be diffused, which makes it impossible to form an extremely shallow junction in which impurities will never be diffused. Also if the processing is carried out under a high temperature, such problems as warping of a wafer will occur. For the reasons as described above, it is necessary to execute the heat processing under a low temperature, because in that case impurities will not be diffused at all.

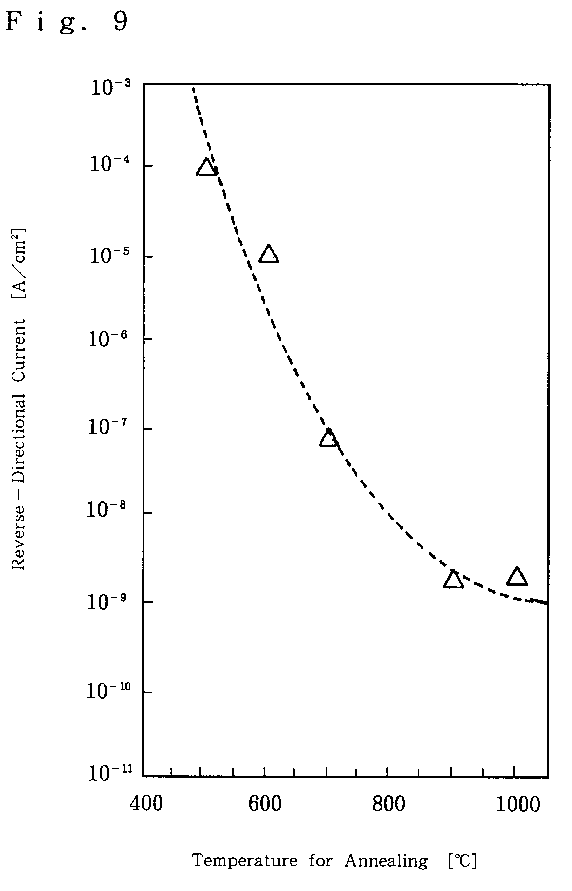

However, in a case where heat processing is carried out under a low temperature, a leak current in the reverse direction in a pn junction of a formed device substantially increases as shown in Fig. 9, which is disadvantageous.

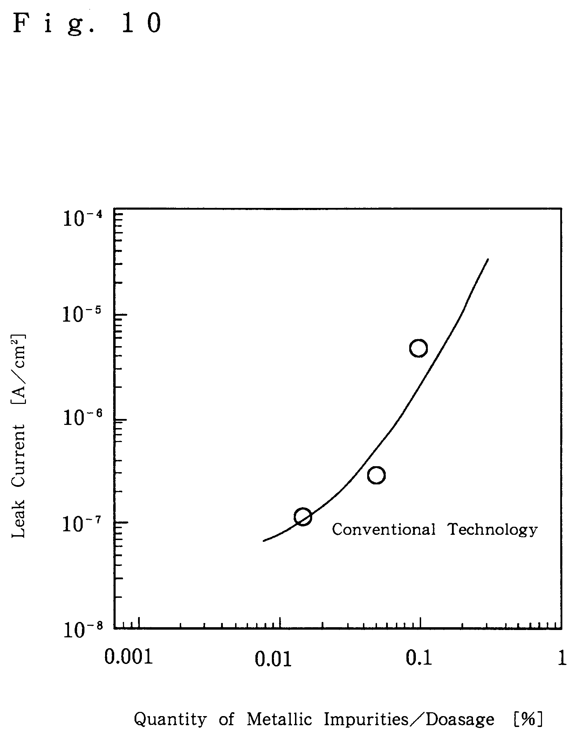

Fig. 10 is a graph showing a relation between a quantity of impurities introduced into a silicon substrate and a leak current in the reverse direction in the pn junction when impurities are introduced into the silicon substrate at a rate of 2 x 10⁵ cm⁻² using an ion implanter and annealing is executed under a temperature of 450°C. It should be noted that, in the figure, a quantity of impurities is expressed with a ratio against a dosage. As clearly understood from Fig. 10, reduction of a quantity of metallic impurities introduced into a silicon substrate is very important for reducing a leak current in the reverse direction in a pn junction.

Also, once metallic impurities are mixed in a silicon substrate, it is extremely difficult to remove the metallic impurities in the subsequent processing, and there is a method of gettering metallic impurities by introducing lattice distortion into a crystal, but the control is very difficult, and there are many problems in this method such as increase of processing steps and warping of a silicon substrate in heat processing under a high temperature. For this reason, essentially it is required to prevent metallic impurities from coming into a silicon substrate.

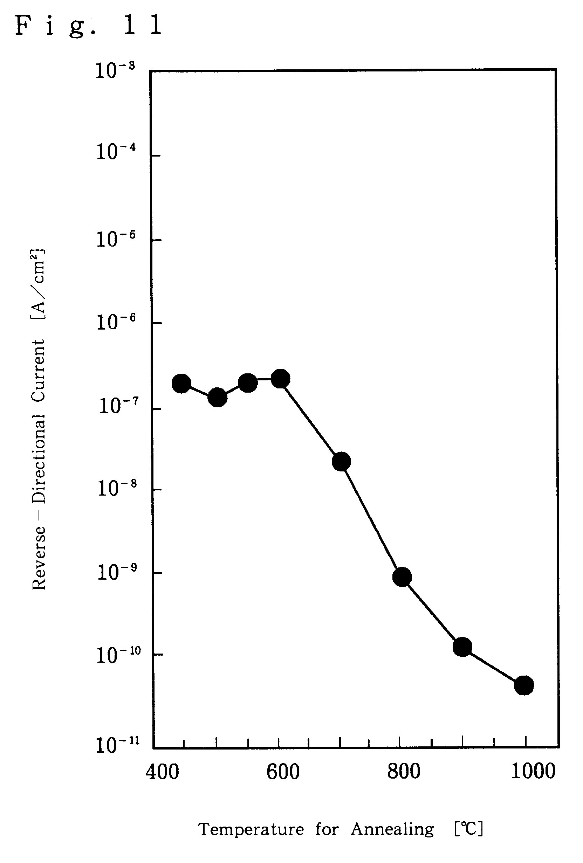

Conventionally, it has been tried in an ion implanter to improve a pn junction reverse directional leak current by reducing contamination by metallic impurities generated from sections forward from a semiconductor substrate when viewed from a direction in which an ion beam advances such as a Faraday cap, a scan plate, or an aperture. A pn junction was formed by using the ion implanter as described above, and a reverse-directional leak current was measures, a result of which is shown in Fig. 11. As shown in Fig. 11, with the technology currently available, the pn-junction reverse-directional leak current can be reduced by only 10⁻⁷ to 10⁻² A/cm if it is tried only to reduce metallic impurities mixed in a semiconductor substrate from sections positioned forward from a ion beam in the ion implanter.

An object of the present invention is to provide an ion implanter which can residue contamination by metallic impurities.

### DISCLOSURE OF THE INVENTION

The ion implanter according to the present invention which introduces specified impurity into said semiconductor substrate by irradiating an accelerated ion beam into a semiconductor is characterized in that a portion of a member positioned backward from said semiconductor substrate and irradiated by said ion beam is made of a semiconductor constituting said semiconductor substrate or a material containing at least one of the oxides or nitrides as a main ingredient, or the surface is covered with the material. Said material is N-type or P-type silicon, and the density of impurities should preferably be 1 x 10¹⁷ cm⁻³ or less.

The ion implanter according to the present invention which introduces specified impurity into said semiconductor substrate by irradiating an accelerated ion beam into a semiconductor is characterized in that a component positioned backward from said semiconductor substrate in the direction in which an ion beam advances is not irradiated by said ion beam.

It is desirable that a partition having an opening is provided at a position forward from said semiconductor substrate to prevent a component positioned at a place backward from said semiconductor substrate from being irradiated by said ion beam, and also it is desirable that said partition is made of a semiconductor constituting said semiconductor or a material containing at least one of the oxides or nitrides, or that the surface is covered with said material.

Said semiconductor substrate is characterized in that the periphery is supported by a substrate supporting material, and at least a surface of said substrate supporting material irradiated by an ion beam is made of semiconductor material constituting said semiconductor or a material containing at least one of the oxides or nitrides as a main ingredient. Furthermore it is desirable that a detection means for detecting said ion beam is provided at a position backward from said semiconductor substrate, a scanning means for scanning said ion beam or a moving means for said semiconductor substrate is controlled according to an output from said detection means, and a component positioned at a place backward from said semiconductor substrate is not irradiated by said ion beam.

### FUNCTION

The present inventors made a research for a relation between a method of and conditions for ion implantation and characteristics of a semiconductor device, and found that, if a component positioned at a place backward from a semiconductor substrate is irradiated by an ion beam during ion implantation, performance of a manufactured semiconductor device such as a reverse-directional leak current in an pn junction becomes lower. The present invention was made based on this discovery.

By using a semiconductor material constituting a semiconductor substrate or a material containing the oxides or nitrides thereof as a main ingredient for a component positioned at a place backward from the semiconductor in the direction in which an ion beam advances, even if the material is sputtered by an ion beam and is scattered over a wafer, as it does not contain any metallic element, contamination by metallic impurities mixed in a silicon substrate can be reduced, and as a result a reverse-direction leak current in a pn junction can be reduced.

Also by preventing a component positioned at a place backward from a semiconductor in the direction in which an ion bean advances from being irradiated by an ion beam, a degree of contamination by metallic impurities generated when a component backward from the wafer is spattered, and as a result it becomes possible to reduce a reverse-directional leak current in an pn junction.

### BRIEF DESCRIPTION OF THE DRAWINGS

Fig. 1 is a concept view for an ion implanter according to a first embodiment of the present invention.
Fig. 2 is a graph showing a relation between a dosage and metallic impurities mixed in a silicon substrate.
Fig. 3 is a graph showing a relation between a quantity of mixed metallic impurities and a reverse-directional leak current.
Fig. 4 is a graph showing a relation between a density if impurities in a silicon plate for spatter prevention and a quantity of impurities scattered over a silicon wafer.
Fig. 5 is a concept view showing an ion implanter showing a second embodiment of the present invention.
Fig. 6 is a concept view showing an ion implanter according to a third embodiment of the present invention.
Fig. 7 is a concept view showing an ion implanter according to a fourth embodiment of the present invention.
Fig. 8 is a concept view showing an ion implanter according to a fifth embodiment of the present invention.
Fig. 9 is a graph showing a relation between a temperature for annealing and a reverse-directional current in a pn junction;
Fig. 10 s a graph showing a relation between a quantity of mixed metallic impurities and a reverse-directional leak current in an pn junction.
Fig. 11 is a graph showing a relation between a temperature for annealing and a reverse-directional leak current in a pn junction.

### (Description of reference numerals)

- 101, 601, 701, 801:: Silicon wafer
- 102, 602, 702, 802:: Electro-static chuck (Wafer holder)
- 103, 703m 803:: Earth pin
- 104, 704, 804:: Tool for fixing an electro-static check (Suscepter)
- 105, 604, 705, 806:: Ion beam
- 106, 605, 711, 807,: Partition
- 603:: Silicon-coated tool
- 706:: Y scanner plate
- 707:: X scanner plate
- 708:: X scan aperture
- 709:: Beam line aperture
- 710:: Faraday cup
- 805:: Arm for mechanically scanning a waver in the vertical as well as horizontal direction

### BEST MODE FOR CARRYING OUT THE INVENTION

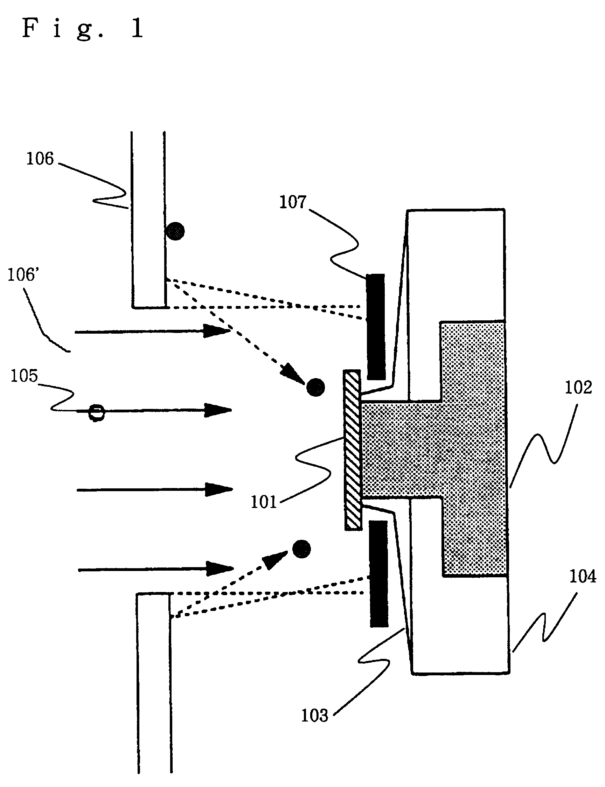

Fig. 1 is a view showing an ion implanter showing a first embodiment of the present invention, and especially shows a cross section of the wafer supporting section.

In this figure, disignated at the reference numeral 101 is a p-type silicon wafer for ions to be implanted therein, at 102 an electro-static chuck (wafer holder) for supporting the silicon wafer, and at 103 an earth pin for earthing an electric potential in the wafer. Also designated at the reference numeral 104 is a tool for fixing the electro-static chuck 102 (susceptor), and is made of, for instance, an Al alloy. An accelerated ion beans is irradiated through an opening section 106' of a partition 106 placed forward from the silicon wafer 102 onto a silicon wafer, and thus ion implantation is executed. This partition 106 is made of, for instance, silicon, and goes not generate contamination by metallic impurities in the silicon wafer even if spattering is executed with an ion beam. The reference numeral 107 indicates a section irradiated by an ion beam, which is a metallic spotter prevention plate provided to prevent contamination of a silicon wafer when metal is spattered from behind the silicon wafer 101. In this embodiment, an Fz silicon wafer having a ring-shaped form and an impurity density from 10⁻¹⁴ cm⁻³ or less was used. The spatter prevention plate covers a section irradiated by an ion beam such as the tool 104 made of an Al alloy or the earth pin 103.

In the device according to the present embodiment, the silicon wafer 101 is supported from its rear face with the electro-static chuck 102 and the earth pin 103, the component 106 positioned at a place forward from the silicon wafer 101 and irradiated by an ion beam is made of an Fz silicon plate with the impurity density of 10⁻¹⁴ cm⁻³ or less, and metallic impurities generated when a surface of a component positioned at a place forward from the silicon wafer 101 is irradiated by an ion beam are not mixed in the silicon wafer 101. Also the components are located in a ultra-high degree vacuum of, for instance, 5 x 10⁻¹⁰ Torr, it is possible to prevent as much as possible a residual gas such as moisture from being deposited on a surface of a wafer and coming into inside of the wafer when irradiated by an ion beam.

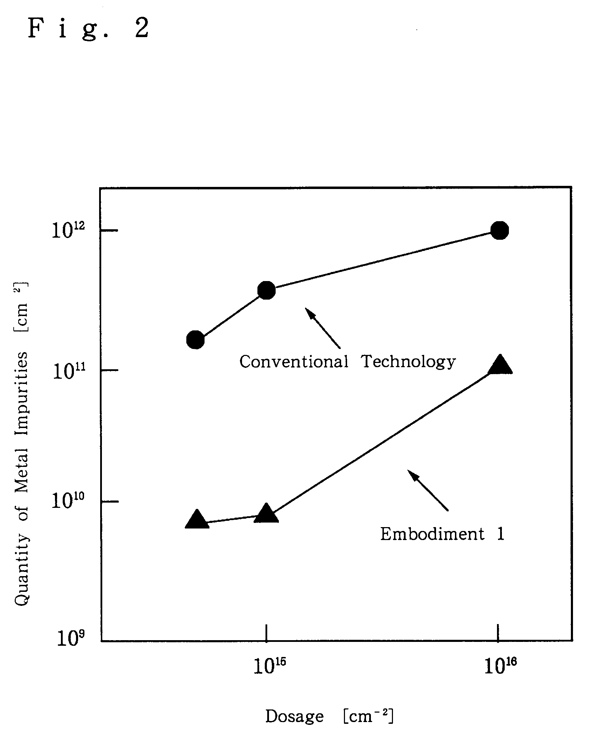

Fig. 2 shows a relation between a dosage and a quantity of metallic impurities coming into inside of a silicon wafer when As ions are implanted into the silicon wafer with a voltage of 25 KeV using an ion implanter according to the present embodiment and that based on the conventional technology. It should be noted that a quantity of metallic impurities was measured with an SIMS. As clearly shown by this figure, when the Fz silicon plate 107 is attached, a quantity of metallic impurities mixed in the silicon wafer 101 is reduced to a one tenth or more lower level in any dosage.

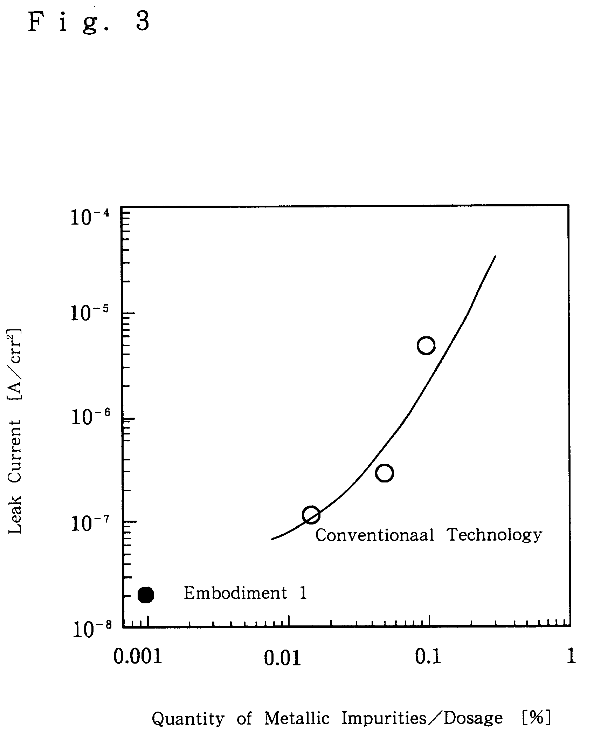

Then an As ions were implanted with a voltage of 2 x 1¹⁵ cm⁻² into a p-type silicon wafer, and then a pn junction was formed by executing annealing under a temperature of 450°C, and the reverse-directional current was measured. Fig. 3 shows a relation between a quantity of mixed metallic impurities (expressed as a ratio against a dosage) and a reverse-directional leak current in a pn junction. In the conventional type of ion implanter, a quantity of mixed metallic impurity is 0.01 %, and the leak current is around 10⁻⁷ A/cm², while in the present embodiment a quantity of mixed metallic impurities can be reduced to a one tenth or more lower level by the Fz silicon plate 107 by preventing metallic impurities generated from a suscepter positioned at a position backward from the wafer with the Fz silicon plate 107, and also the leak current was reduced to around one tenth of the original level, and a low leak pn junction in which a leak current was 10⁻⁸ A/cm² was obtained.

In other words, with the present invention, it becomes possible for the first time to form a practical pn junction under a low temperature of 450°C. With this, it has become possible to form a junction by executing ion implantation for a self-adjusting source drain using an Al gate to provide an Al gate electrode and then executing annealing.

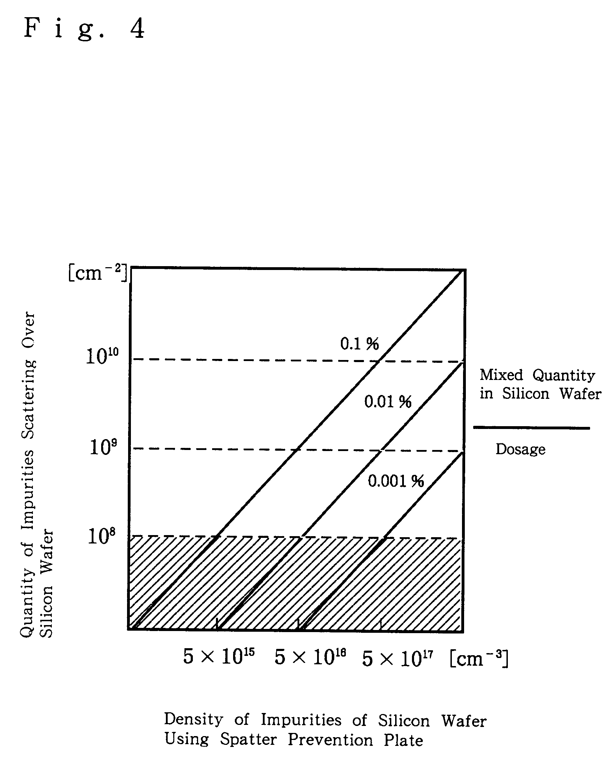

Fig. 4 is a graph showing a relation between a density of impurities in the Fz silicon wafer 107 using a spatter prevention plate therein and a quantity of impurities scattering over the silicon wafer when oxygen ions are implanted by a volume of 1 x 10¹⁸ cm⁻² in the SIMOX process.

In order to control a threshold value for a minute device (with a oxide film thickness of 50 nm) with a power voltage of 1 V and a threshold voltage of 0.1 V, it is required to suppress a quantity of impurities scattered over the silicon wafer to 4 x 10⁸ cm⁻² or less, and preferably to 1 x 10⁸ cm⁻² or less.

On the other hand, the mixing ratio (a ratio of a quantity of impurities scattering over a silicon wafer in spattering vs. a dosage) varies for each ion implanter, but generally it is estimated that the ratio is in a range from 0.001 to 0.1 %. For this reason, it is understood from Fig. 4 that , when the mixing ratio is 0.001 %, an impurity density in the spatter prevention plate 107 should be suppressed to 5 x 10¹⁷ cm⁻³ or less. The density should be suppressed to 5 x 10¹⁶ cm⁻³ or less for the mixing ratio of 0.01 %, and to 5 x 10¹⁵ cm⁻³ or less for the mixing ratio of 0.1 %. Especially the density of 5 x 10¹⁴ cm⁻³ or less is preferable, and with level of impurity density as described above, precise control over the impurity density becomes possible.

The Fz silicon wafer 107 nay be replaced with a new one if high density ion implantation is executed repeatedly at a certain interval. Namely, with simple maintenance, reduction of a degree of contamination can easily be achieved.

The above description concerning the present embodiment assumes a case where the impurity density in an Fz silicon wafer is 1 x 10¹⁴ cm⁻³ or less, but a Cz silicon wafer or an EPi silicon wafer may be used for the same purpose. Also as described above, the impurity density may be above 1 x 10¹⁴ cm⁻³ or more, and also a Cz silicon wafer with the impurity density of around 10¹⁵ cm⁻³, which is commonly used, may be used for this purpose. Also the higher impurity density is allowable. However, a lower impurity density in a silicon wafer is preferable. Also a material other than silicon such as silicon oxide or silicon nitride may be used as a material for the spatter prevention plate 107. For, when ions are implanted through a silicon oxide film, if the spatter prevention plate 107 is made of a silicon oxide, even if metallic impurities come into the silicon wafer in spattering, the impurities do not cause contamination. Also no problem occurs even if ion implantation is executed using a silicon oxide film as a mask, and same is true for a case where a silicon nitride film is used in place of he silicon oxide film.

Also the above description of the present embodiment assumes a case where an Fz silicon wafer is used as the spatter prevention plate 107, but silicon or silicon oxide or silicon nitride may be deposited directly on the suscepter 104 by means of CDV or spattering.

Furthermore, although a silicon wafer was used as a semiconductor substrate in the present embodiment, but the silicon wafer used in the present invention is not limited to a silicon semiconductor, and the present invention can advantageously be applied also to Ge or other compound semiconductors.

### (Embodiment 2)

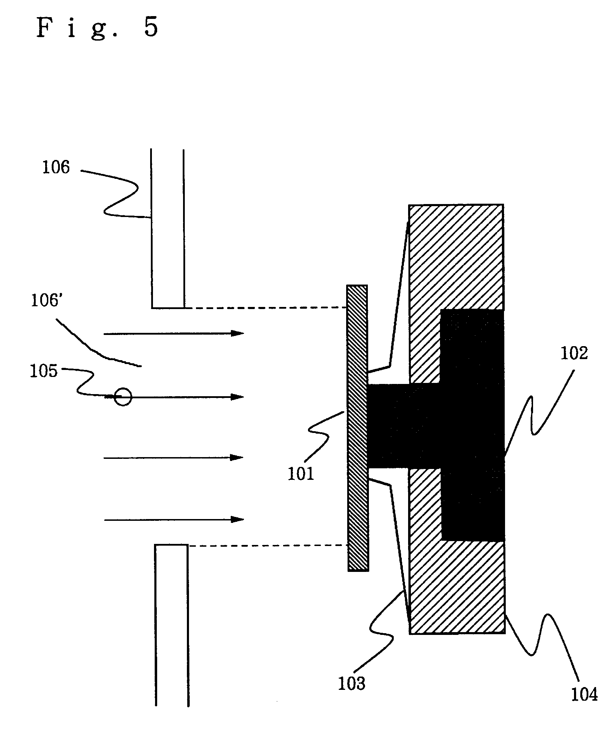

Fig. 5 is a view showing an ion implanter according to a second embodiment of the present invention, and especially shows a cross section of the wafer supporting section. It should be noted that the same reference numerals as those in Fig. 1 are assigned to the same sections as those in Fig. 1.

In the present embodiment, a diameter of the opening section 106' is designed so that the ion beam is not irradiated onto the silicon holder 104 located backward from the silicon wafer 101. This partition 106 comprises a silicon plate, and does not cause contamination by metallic impurities on the silicon wafer 101 even if it is spattered by an ion beam. In this embodiment, an Fz silicon wafer with the impurity density of 10¹⁴ cm⁻³ was used as the silicon plate. It should be noted that in this embodiment, a diameter of the silicon wafer 101 is 33 mφ, an opening of the partition 106 is 28 mmφ, and a distance between the partition and the silicon wafer 101 is 200 mm.

In this embodiment, the silicon wafer 101 having a diameter of 33 mmφ was used, but the diameter may be 6 inches or 8 inches or more, and in these cases, a diameter of the opening in the partition should be set to a value slightly smaller than a diameter of the wafer. Also the distance between the partition and the silicon wafer is not always limited to the value used in the embodiment above so long as the distance is smaller than a distance between the X scan plate and Y scan plate each deciding a scan area of the wafer. Preferably, the partition should be closer to the silicon wafer, and with this spatter behind the silicon wafer can be prevented more precisely.

Also the above description concerning the present invention assumes a case of an electro-statically polarized type of ion implanter, but the same is true also for a parallel scan system, and in this case, an opening in the partition should preferably have a diameter equal to or smaller than a diameter of the wafer.

Using the device described above, like in Embodiment 1, As ions were implanted into a silicon wafer with a voltage;of 25 KeV, and a quantity of metallic impurities on the silicon wafer was measured, and it was confirmed that the quantity was deduced to one tenth of that in the conventional technology like in Embodiment 1.

Further, a leak current in pn junction was measured like in Embodiment 1, and the quantity was around 10¹⁶ A/cm², and it was confirmed that the ion implanter according to the present invention could effectively suppress contamination by metallic impurities.

Also description of the present embodiment above assumes a case where the opening 106' in the partition 106 is round, but when ions are implanted into a square liquid crystal panel, a form of the opening 106' should be square.

### (Embodiment 3)

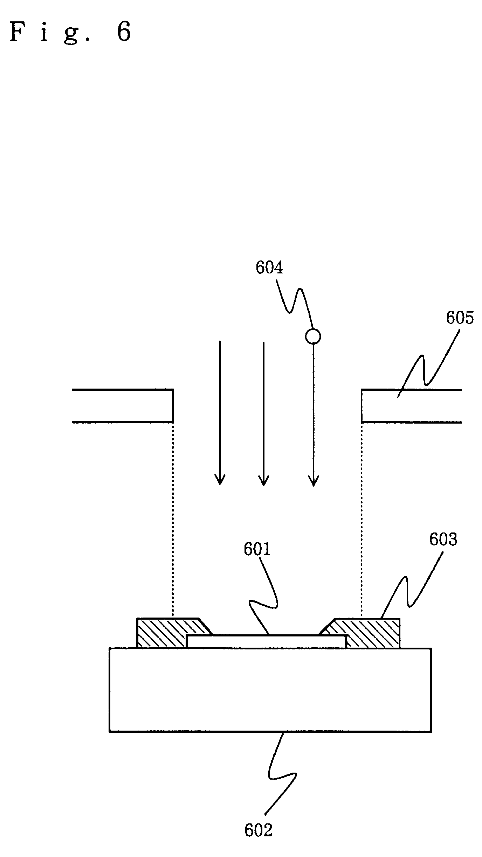

Fig. 6 is a view showing an ion implanter according to a third embodiment of the present invention, and especially shows a cross section of the wafer supporting section. In this figure, a silicon wafer, to which ions are implanted, is supported with a tool 603 coated with silicon according to the present invention by a wafer holder 602. This tool 603 is made by having silicon deposited by a thickness of 1 µm on an aluminum alloy by means of the CVD method, and it is designed so that an ion beam will be larger than a area to be scanned. For this reason, an ion beam is irradiated to, in addition to the silicon wafer, only to the silicon-coated tool 603, and contamination by metallic impurities is not generated there. It should be noted that an area of the tool 603 irradiated by an ion beam should preferably be smaller, and in a case where the silicon wafer 601, into which ions are to be implanted, is round, scanning with an ion beam is executed in a round form, and it is required to prepare a round tool 603 slightly larger than the round form for scanning, and in a case where scanning is executed in a square form, the tool 603 should also preferably be square.

The above description concerning the present invention assumes that the tool 603 was formed by coating silicon with a thickness of 1 µm by means of the CVD method, but this thickness should not always be limited to 1µm. This thickness varies according to a voltage for acceleration or a species of ions, and in the present embodiment the thickness is set to 1 µm for margin. Also the density of silicon deposited by the CVD method varies according to a purpose, but preferably non-dope silicon should be used.

The above description of the present invention assumes use of the silicon-coated tool 603, but a tool made of silicon or a tool made of aluminum alloy with a silicon wafer adhered thereto may be used.

Also the above description of the present invention assumes use of the silicon-coated tool 603, but the same effect can be achieved also by having silicon oxide or silicon nitride deposited on the tool 603.

Furthermore the above description of the present invention assumes use of silicon, but in a case where a semiconductor substrate is made of Ge-based semiconductor or compound-based semiconductor such as GaAs, the same effect can be achieved by coating the tool with a material containing at least one of the semiconductor, the oxide, or the nitride thereof as the main ingredient.

### (Embodiment 4)

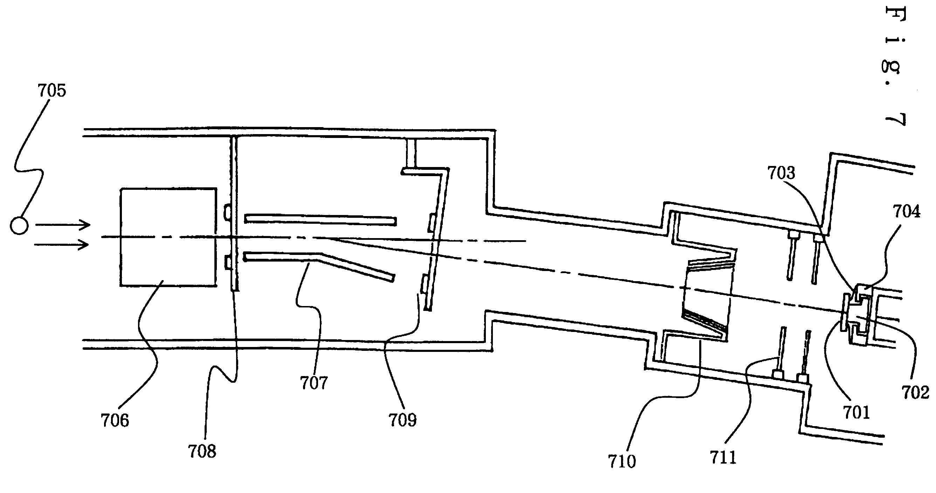

Fig. 7 is a view showing an ion implanter according to a fourth embodiment of the present invention, and especially shows a cross section of the wafer supporting section viewed from the beam line. In this figure, designated at the reference numeral 701 is a silicon wafer (with a diameter of 33 mmφ) into which ions are implanted, at 702 an electro-static chuck for supporting the silicon wafer, and at 703 an earth pin for earthing electric potential in the wafer. Also the reference numeral indicates a tool for supporting the electro- -static chuck 702, which is made of, for instance, an Al alloy.

The accelerated ion beam 705 is scanned by a Y scanner plate 706 and an X scanner plate 707 (ion beam scanning means) in the X and Y directions respectively, and is irradiated through an X scanner aperture 708, a beam aperture 709, a Faraday cup 710, and a round opening (with a diameter of 40 mmφ) in a partition 711 located forward from the silicon wafer 701 onto the silicon wafer 701, and thus ion implantation is executed. It should be noted that a distance between the partition 711 and the silicon wafer 701 is set to 200 mm.

In this step, the ion beam 705 is controlled and scanned by the Y scanner plate 706 and X scanner plate 707 in the X and Y directions respectively so that the beam 705 is used for ion implantation into the internal side of the silicon wafer 701 without irradiating the wafer holder 704 at all. When ions are implanted into a square liquid crystal panel, scanning is executed in a square form without executing over scan, and also when ions are implanted into a round silicon wafer, scanning is executed in a round form. A range for scanning is simply according to a position of a wafer holder and a size of the silicon wafer. Furthermore, an ion beam detecting means such as a later stage Faraday cup is provided at a place backward from the silicon wafer, and the Y scanner plate 706 and the X scanner plate 707 can be controlled on real time, when an ion beam is detected, by feed backing the information.

The above description of the present embodiment assumes use of an electro-statically polarized type of ion implanter, but the same effect can be achieved also in a case of parallel injection ion implanter.

### (Embodiment 5)

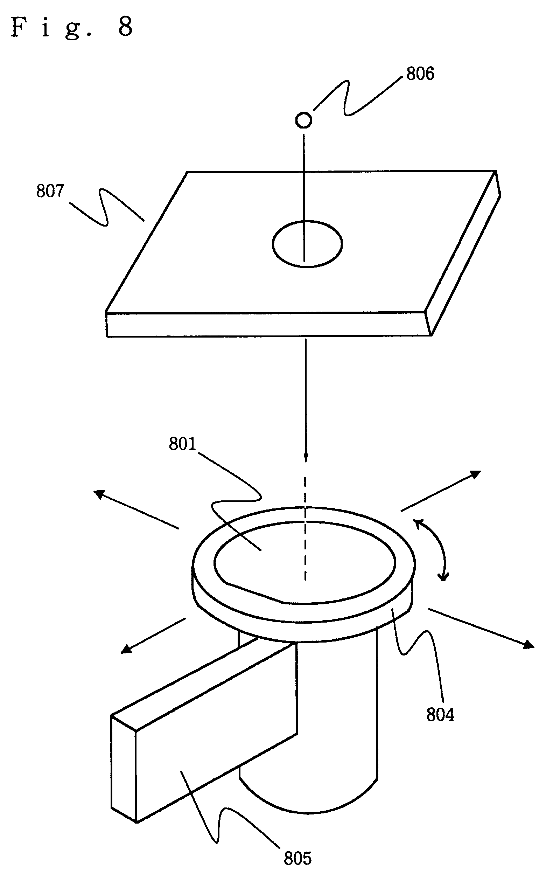

Fig. 8 is a view showing an ion implanter according to a fifth embodiment of the present invention, and especially shows the wafer supporting holder. In this figure, a silicon wafer 801 into which ions are implanted is supported by an electro-static chuck (not shown) and an earth pin (not shown) from a rear surface of the wafer. Also the reference numeral 805 indicates a tool for fixing the electro-static chuck, while the reference numeral 805 indicates an arm having a mechanism for moving a wafer in the vertical and horizontal directions and also for rotating the wafer.

An accelerated ion beam 806 is not scanned and is irradiated onto a silicon wafer at a constant level through an opening section in a partition 807 made of silicon, and thus ion implantation is executed. In this step, Scanning is executed in the X and Y directions by mechanically controlling a silicon wafer so that the ion beam 806 implants only into the internal side of the silicon wafer 801 without irradiating the wafer holder 804 at all. When ions are implanted into a square panel, the wafer is scanned in a square form without executing over scan, and also when ions are implanted into a round silicon wafer, the wafer is scanned in a round form. A range for scanning can easily be decided according to a size and a form of a silicon wafer. When an internal side of a silicon wafer is scanned, an area of the range for scanning should preferably be as large as possible. For, in that case the silicon wafer can be utilized more effectively.

In this embodiment, to implant ions into a silicon wafer uniformly, it is required only to execute scanning by controlling the scanning speed in the vertical and horizontal directions. Also uniform ion implantation may be executed by rotating a wafer and scanning it in the right and left (up and down) directions.

Also the description of the present embodiment above assumes use of a mechanical scan type of ion implanter, but the same effect can be achieved by using a hybrid type of ion implanter based on an electro-statically polarized type of scan system or a combination of a parallel scan system and a mechanical scan system.

### Industrial Availability

As described above, with the invention according to Claim 1, when viewed from a direction in which an ion beam advances, contamination by metallic impurities from a component positioned at a place backward from a semiconductor substrate is reduced, and a high performance semiconductor device such as a semiconductor device in which a reverse-directional leak current is little generated in a pn junction is provided.

With the invention according to Claim 3, contamination by metallic impurities from a component at a place backward from a semiconductor substrate is eliminated, and a semiconductor in which a reverse-directional leak current in a pn junction is little generated is provided.

## Claims

1. An ion implanter for introducing specified impurities into said semiconductor substrate by irradiating an ion beam accelerated against the semiconductor; wherein a portion of a component at a place backward from said semiconductor substrate, said portion irradiated by said ion beam when viewed from a direction in the ion beam advances, is made of semiconductor constituting said semiconductor substrate or a material containing at least the oxide or nitride thereof as a main ingredient, or the surface is covered with said material.

2. The ion implanter according to Claim 1, wherein said material is an N-type of a P-type silicon, and the impurity density is 1 x 10¹⁷ cm³ or less.

3. An ion implanter for introducing specified impurities into said semiconductor substrate by irradiating an ion beam accelerated against the semiconductor; a component positioned at a place backward from said semiconductor substrate, when viewed from a direction in which the ion beam advances, is not irradiated by said ion beam.

4. The ion implanter according to Claim 3; wherein a partition having an opening is provided at a place forward from said semiconductor substrate, and said partition prevents a component positioned at a place backward from said semiconductor substrate from being irradiated by said ion beam.

5. The ion implanter according to Claim 4; wherein said partition is made of semiconductor constituting said semiconductor substrate or a material containing at least an oxide or a nitride thereof as a main ingredient, or the surface is covered with said material.

6. An ion implanter according to Claim 5; wherein said material is an N-type or a p-type of silicon and the impurity density is 1 x 10¹⁷ cm⁻³ or less.

7. The ion implanter according to Claim 3; wherein an external periphery of said semiconductor substrate is supported by a substrate supporting member, and at least a surface of said substrate supporting member is made of semiconductor constituting said semiconductor device or a material containing at least an oxide or a nitride thereof as a main ingredient.

8. The ion implanter according to Claim 3; wherein a detecting means for detecting said ion beam is provided at a place backward from said semiconductor substrate, and a scanning means for scanning said ion beam or a moving means for moving said semiconductor substrate is controlled according to an output from said detecting means so that a member positioned at a place positioned backward from said semiconductor substrate is not irradiated by said ion beam.
